(19) **Europäisches Patentamt**

**European Patent Office**

**Office européen des brevets**

(11) **EP 0 884 837 B1**

(12) **EUROPÄISCHE PATENTSCHRIFT**

(45) Veröffentlichungstag und Bekanntmachung des Hinweises auf die Patenterteilung:
**21.09.2005 Patentblatt 2005/38**

(51) Int Cl.⁷: **H03F 1/32**

(21) Anmeldenummer: **98201931.7**

(22) Anmeldetag: **09.06.1998**

(54) **Schaltungsanordnung mit Differenzverstärkerstufen**

Circuitry comprising differential amplifying stages

Circuit avec des étages d'amplification différentielles

(84) Benannte Vertragsstaaten:
**DE FR GB IT**

(30) Priorität: **14.06.1997 DE 19725286**

(43) Veröffentlichungstag der Anmeldung:
**16.12.1998 Patentblatt 1998/51**

(73) Patentinhaber:
• **Philips Intellectual Property & Standards GmbH**
**20099 Hamburg (DE)**
Benannte Vertragsstaaten:
**DE**
• **Koninklijke Philips Electronics N.V.**
**5621 BA Eindhoven (NL)**
Benannte Vertragsstaaten:
**FR GB IT**

(72) Erfinder: **Dick, Bernhard**
**Röntgenstrasse 24, 22335 Hamburg (DE)**

(74) Vertreter: **Peters, Carl Heinrich et al**
**Philips Intellectual Property & Standards GmbH,**
**Postfach 50 04 42**
**52088 Aachen (DE)**

(56) Entgegenhaltungen:
**EP-A- 0 312 017**          **EP-A- 0 400 650**
**US-A- 5 307 024**

**Beschreibung**

Die Erfindung bezieht sich auf eine Schaltungsanordnung mit

- einer ersten Differenzverstärkerstufe mit zwei Verstärkungselementen, deren Hauptstrompfade

  -- einerseits miteinander und über eine erste Bezugsstromquelle mit einem ersten Bezugspotential gekoppelt sind und
  -- andererseits mit je einem Ausgangsanschluß sowie über je eine Ausgangsimpedanz mit einem zweiten Bezugspotential gekoppelt sind und deren Steueranschlüssen ein erstes Steuersignal zuleitbar ist, wobei den Ausgangsanschlüssen ein Ausgangssignal entnehmbar ist,

- wenigstens einer weiteren Differenzverstärkerstufe mit je zwei weiteren Verstärkungselementen, deren Hauptstrompfade je einerseits miteinander und über je eine weitere Bezugsstromquelle mit dem ersten Bezugspotential gekoppelt sind und deren Steueranschlüssen so ein weiteres Steuersignal zuleitbar ist.

In Schaltungsanordnungen, die auf einem Halbleiterkörper integriert sind, werden sehr oft Differenzverstärkerstufen benutzt, die Verstärkungselemente umfassen, die bevorzugt aus bipolaren Transistoren gebildet werden. Eingänge dieser Differenzverstärkerstufen werden dann durch Basisanschlüsse der bipolaren Transistoren gebildet. Die Transistoren sind ferner mit ihren Emitteranschlüssen entweder unmittelbar verbunden und bilden dann einen nicht gegengekoppelten Differenzverstärker, oder sie sind durch Widerstandsgegenkopplung linearisiert. In letzterem Fall sind die Linearisierungswiderstände als Emitterwiderstände mit den Emitteranschlüssen der Transistoren verbunden und liegen in Reihe mit den Hauptstrompfaden der Verstärkungselemente. Die Größe der Gegenkopplung wird durch die Anforderung an die Rauschzahl, die Linearität und die Verstärkung der Differenzverstärkerstufe bestimmt. Dabei wird als Maß für die Linearität beispielsweise der Klirrfaktor oder die Größe der sogenannten Intermodulationsprodukte IPn mit n = 2,3,4... herangezogen. Diese Intermodulationsprodukte, die sich im Ausgangssignal der Differenzverstärkerstufe als Störprodukte bemerkbar machen, entstehen bei einer Übertragung von mindestens zwei Signalen unterschiedlicher Frequenzen allgemein über ein System mit nichtlinearer Übertragungskennlinie, im vorliegenden Fall die Differenzverstärkerstufe, durch sogenannte Kreuzmodulation. Sie können die Qualität des verarbeiteten Signals empfindlich beeinträchtigen.

Aus dem Aufsatz "A Linearization Technique for Variable Transconductors Using Emitter Coupled Pairs and Its Application to a 1-Volt Active Filter", veröffentlicht in "Proceedings of ESSCIRC '90", Seiten 165 bis 168, ist eine Schaltungsanordnung bekannt, bei der eine Linearisierung der Kennlinie von Differenzverstärkerstufen der beschriebenen Art durch Parallelbetrieb mehrerer individueller Differenzverstärkerstufen erzeugt wird. Die einzelnen Differenzverstärkerstufen erhalten dabei geeignete Verschiebungen ihrer Eingangsspannungen und Gewichtungen ihrer "Stromschwänze". Außerdem werden die Emitterflächen der verwendeten Transistoren im vorgegebenen Verhältnis zueinander gewählt.

Weitere derartige Anordnungen mit parallelen Differenzverstärkern sind aus EP-A-0 312 017 bekannt.

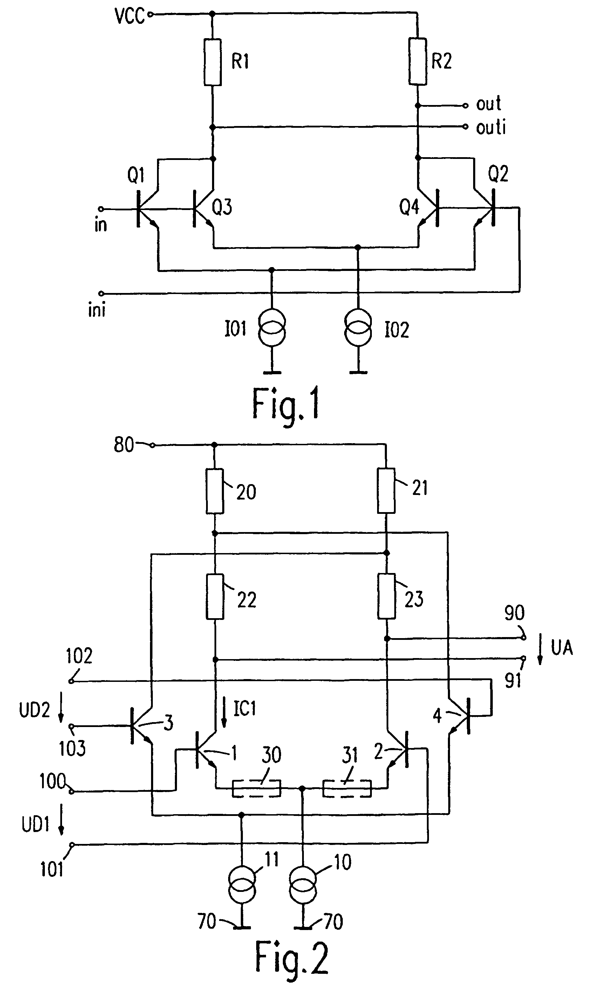

Fig. 1 zeigt eine in dieser Weise aufgebaute Schaltungsanordnung zur Linearisierung einer nicht gegengekoppelten Differenzverstärkerstufe. Zur Vereinfachung der Erläuterung werden bei der in Fig. 1 dargestellten Schaltungsanordnung gegenüber dem vorstehend zitierten Aufsatz lediglich zwei Differenzverstärkerstufen, d.h. zwei emittergekoppelte Transistorenpaare, dargestellt. Dabei bilden die mit den Bezugszeichen Q1 und Q2 bezeichneten Transistoren eine erste Differenzverstärkerstufe und die mit den Bezugszeichen Q3 und Q4 bezeichneten Transistoren eine zweite Differenzverstärkerstufe. Die Emitterflächen der Transistoren Q1 und Q4 sind einander gleich und um einen vorgegebenen Faktor größer als die untereinander ebenfalls gleichen Emitterflächen der Transistoren Q2 und Q3. Die Emitter der Transistoren Q1, Q2 der ersten Differenzverstärkerstufe sind unmittelbar miteinander verbunden und über eine erste Konstantstromquelle I01 an Masse angeschlossen. Entsprechend sind die Transistoren Q3, Q4 der zweiten Differenzverstärkerstufe unmittelbar miteinander verbunden und über eine zweite Konstantstromquelle I02 an Masse angeschlossen. Die Basisanschlüsse der Transistoren Q1 und Q3 sind mit einem Eingangsanschluß in, die Basisanschlüsse der Transistoren Q2 und Q4 mit einem zweiten Eingangsanschluß ini verbunden. Die Kollektoranschlüsse der Transistoren Q1, Q3 sind miteinander mit einem Ausgangsanschluß outi und über einen Kollektorwiderstand R1 mit einem Versorgungsspannungsanschluß VCC verbunden. Entsprechend besteht eine Verbindung zwischen den Kollektoranschlüssen der Transistoren Q2, Q4 und einem weiteren Ausgangsanschluß out über einen zweiten Kollektorwiderstand R2 an den Versorgungsspannungsanschluß. Im Gegensatz zu der in dem obigen Aufsatz beschriebenen Schaltungsanordnung sind die Arbeitsimpedanzen der Differenzverstärkerstufen als Widerstände R1, R2 ausgeführt, was jedoch die Funktion der Schaltungsanordnung nicht grundsätzlich verändert.

Bei der Schaltungsanordnung nach Fig. 1 ist der Nulldurchgang der Differenzverstärkerkennlinie bei einer der Differenzverstärkerstufen zu negativeren Eingangsspannungen und bei der anderen Differenzverstärkerstufe zu positiveren Eingangsspannungen hin gleichermaßen verschoben, so daß durch die Addition der beiden Kennlinie die differentielle Ausgangsspannung frei von Gleichspannungsverschiebungen ("offsetfrei") ist und eine Linearisierung der überlagerten Kennlinie stattfindet. Speziell für ein Flächenverhältnis zwischen den Emitterflächen der Transistoren Q1, Q4 einerseits und Q2, Q3 andererseits von 4:1 wird eine Kompensation des nichtlinearen Anteils dritter Ordnung in der Spannung an den Ausgangsanschlüssen out, outi erreicht.

Durch eine Parallelschaltung mehrerer derartiger Differenzverstärkerstufen mit entsprechend gewählten Flächenverhältnissen in der gleichen Weise kann eine weitere Linearisierung erreicht werden.

Es zeigt sich jedoch, daß bei der beschriebenen Schaltungsanordnung beispielsweise für eine Kompensation des nichtlinearen Anteils dritter Ordnung mit einem Flächenverhältnis von 4:1 die Verstärkung der gesamten Schaltungsanordnung gegenüber derjenigen einer einfachen Differenzverstärkerstufe um 3,8 dB entsprechend einem Faktor von 1,55 reduziert wird. Mit dieser Verringerung der Verstärkung geht eine entsprechende Erhöhung der Rauschzahl einher. Darüber hinaus ist die relative Streuung von Flächenverhältnissen von Emitterflächen von bipolaren Transistoren auf integrierten Schaltkreisen relativ groß, und zwar größer als bei z.B. integrierten Widerständen. Dadurch ergeben sich Fertigungstoleranzen, die das erreichte Ergebnis der angestrebten Linearisierung verschlechtern können.

Die Erfindung hat die Aufgabe eine Schaltungsanordnung mit einer Differenzverstärkerstufe der eingangs genannten Art zu schaffen, die eine Linearisierung der Kennlinie mit höherer Zuverlässigkeit bei höherer Verstärkung und damit niedriger Rauschzahl ermöglicht.

Erfindungsgemäß wird diese Aufgabe dadurch gelöst, daß

- die Ausgangsimpedanzen als vorzugsweise gleiche Spannungsteiler mit für jede weitere Differenzverstärkerstufe je einer Anzapfung ausgebildet sind,
- die Hauptstrompfade der weiteren Differenzverstärkerstufen an je zwei paarweise zueinander symmetrische, eine vorbestimmte Teilung aufweisende Anzapfungen beider Spannungsteiler geführt sind,
- die Augenblickswerte der Steuersignale in vorgewähltem Verhältnis zueinander stehen und
- die Teilung der Anzapfungen der Spannungsteiler und das Verhältnis der von den Bezugsstromquellen abgegebenen Ströme derart aufeinander abgestimmt sind, daß sich im Ausgangssignal Anteile aufheben, die eine Abhängigkeit von wenigstens einer höheren Potenz der Steuersignale zeigen.

Bei dieser erfindungsgemäßen Schaltungsanordnung können bevorzugt die Verstärkungselemente aller Differenzverstärkerstufen wenigstens bezüglich ihrer Hauptstrompfade übereinstimmend dimensioniert werden. Damit entfallen von 1 verschiedene Flächenverhältnisse der einzusetzenden Transistoren. Dies eliminiert eine wesentliche, fertigungstechnisch bedingte Fehlerquelle der angestrebten Linearisierung.

Die Erfindung erlaubt die Linearisierung sowohl einer nicht gegengekoppelten Differenzverstärkerstufe als auch einer Differenzverstärkerstufe mit Gegenkopplung. Die Hauptstrompfade der Verstärkungselemente der ersten Differenzverstärkerstufe können zur Verwirklichung dieser Gegenkopplung mit der ersten Bezugsstromquelle über je eine Rückkopplungsimpedanz verbunden sein.

Die Erfindung ist bevorzugt für die Linearisierung von Schaltungsanordnungen mit Differenzverstärkerstufen in integrierten elektronischen Halbleiterbausteinen einsetzbar. Sie eignet sich insbesondere für Differenzverstärkerstufen, die mit niedrigen Versorgungsspannungen betrieben werden. Daher ist die Erfindung insbesondere für Telekommunikationsgeräte und hierunter vorzugsweise für batteriegespeiste, beispielsweise schnurlose Telekommunikationsgeräte, einsetzbar.

In der Zeichnung finden sich außer einer Darstellung zum Stand der Technik auch Schaltungsbeispiele zur Erläuterung der Erfindung. Demgemäß zeigen

- Fig. 1 eine Schaltungsanordnung, die im Zusammenhang mit der Darstellung des Standes der Technik erläutert wurde,
- Fig. 2 ein erstes Ausführungsbeispiel der Erfindung,
- Fig. 3 eine Schaltungsanordnung zum Einsatz mit dem ersten Ausführungsbeispiel und
- Fig. 4 ein zweites Ausführungsbeispiel der Erfindung.

Die als erstes Ausführungsbeispiel in Fig. 2 dargestellte Schaltungsanordnung umfaßt eine erste Differenzverstärkerstufe mit einem ersten Verstärkungselement 1 und einem zweiten Verstärkungselement 2. Jedes Verstärkungselement 1, 2 weist einen Hauptstrompfad zwischen zwei Hauptstromanschlüssen und je einen Steueranschluß auf. Im Beispiel nach Fig. 2 sind die Verstärkungselemente 1, 2 als bipolare Transistoren vom NPN-Typ ausgebildet, ihre Hauptstromanschlüsse werden durch die Kollektor- bzw. Emitteranschlüsse gebildet, und die Steueranschlüsse werden durch die Basisanschlüsse dargestellt. Die Hauptstrompfade dieser NPN-Transistoren werden durch die Kollektor-Emitter-Strecken der NPN-Transistoren gebildet. Vom ersten und vom zweiten Verstärkungselement 1, 2 ist je ein erster der Hauptstromanschlüsse, im dargestellten Beispiel die Emitteranschlüsse, mit einem ersten Anschluß einer ersten Konstantstromquelle 10 gekoppelt. Ein zweiter Anschluß der Konstantstromquelle 10 ist an ein erstes Bezugspotential geführt, das in Fig. 2 durch den Masseanschluß 70 gebildet ist. Die Kopplung zwischen den ersten Hauptstromanschlüssen (Emitteranschlüssen) der Verstärkungselemente 1, 2 und dem ersten Anschluß der ersten Konstantstromquelle 10 erfolgt im Fall einer nicht gegengekoppelten Differenzverstärkerstufe unmittelbar und im Fall einer gegengekoppelten Differenzverstärkerstufe über je eine Gegenkopplungsimpedanz 30 bzw. 31. Die Gegenkopplungsimpedanzen 30, 31 sind im Regelfall als ohmsche Widerstände ausgebildet und werden dann auch als Emitterwiderstände bezeichnet.

Das erste und das zweite Verstärkungselement 1, 2 ist mit je einem zweiten seiner Hauptstromanschlüsse, d.h. im Beispiel nach Fig. 2 mit dem zugehörigen Kollektoranschluß, mit einem zweiten Bezugspotential 80 gekoppelt. In Fig. 2 stellt ein Versorgungsspannungsanschluß dieses zweite Bezugspotential 80 dar. Die zweiten Hauptstromanschlüsse (Kollektoranschlüsse) der Verstärkungselemente 1, 2 bilden außerdem je einen Ausgangsanschluß 90 bzw. 91 der ersten Differenzverstärkerstufe. Den Steueranschlüssen der Verstärkungselemente 1, 2, die in Fig. 2 durch Basisanschlüsse der die Verstärkungselemente darstellenden NPN-Transistoren gebildet werden, ist im Betrieb eine erste Steuerspannung UD1 zuleitbar. Die Übertragungskennlinie zwischen dieser Steuerspannung UD1 und einer Ausgangsspannung UA an den Ausgangsanschlüssen 90, 91 gehorcht einer Tangens-Hyperbolicus-Funktion, wie in der Monografie "Halbleiter-Schaltungstechnik" von U. Tietze und Ch. Schenk, 4. Auflage, Seite 63, beschrieben. Diese Kennlinie führt bei hinreichend großer Aussteuerung durch die Steuerspannung zu Nichtlinearitäten, d.h. zu Anteilen höherer Harmonischer in der Ausgangsspannung UA.

Gemäß der Erfindung ist bei der Schaltungsanordnung nach Fig. 2 eine zweite Differenzverstärkerstufe vorgesehen, die ein drittes und ein viertes Verstärkungselement 3 bzw. 4 umfaßt. Auch das dritte und vierte Verstärkungselement weisen je einen Hauptstrompfad zwischen zwei Hauptstromanschlüssen und je einen Steueranschluß auf. In Fig. 2 sind auch das dritte und vierte Verstärkungselement 3, 4 als NPN-Transistoren mit Emitter- und Kollektoranschluß als erstem bzw. zweitem Hauptstromanschluß und Basisanschluß als Steueranschluß ausgestaltet. Je ein erster der Hauptstromanschlüsse (Emitteranschlüsse) des dritten und vierten Verstärkungselements 3, 4 ist mit einem ersten Anschluß einer zweiten Konstantstromquelle 11 verbunden. Ein zweiter Anschluß dieser zweiten Konstantstromquelle 11 ist an das erste Bezugspotential, d.h. an den Masseanschluß 70, geführt. Den Steueranschlüssen des dritten und vierten Verstärkungselements 3, 4 ist im Betrieb eine zweite Steuerspannung UD2 zuleitbar. Zum Zuleiten der Steuerspannungen UD1, UD2 sind die Steueranschlüsse der Verstärkungselemente 1 bis 4 mit Eingangsanschlüssen 100, 101, 103 bzw. 102 verbunden.

Die zweiten Hauptstromanschlüsse, d.h. die Kollektoranschlüsse, des ersten und des vierten Verstärkungselements 1, 4 einerseits und des zweiten und dritten Vertärkungselements 2, 3 andererseits sind über je eine Spannungsteilerstufe mit dem zweiten Bezugspotential, dem Versorgungsspannungsanschluß 80, gekoppelt. Dabei umfaßt die erste Spannungsteilerstufe zwei in Reihe angeordnete Widerstände 20, 22, die zweite Spannungsteilerstufe umfaßt zwei weitere, ebenfalls in Reihe angeordnete Widerstände 21, 23. Jede der Spannungsteilerstufen enthält wenigstens eine Anzapfung, die mit je einem der zweiten Hauptstromanschlüsse (Kollektoranschlüsse) des dritten und des vierten Verstärkungselements verbunden ist. Durch die Anzapfungen, d.h. die Dimensionierung der Widerstände 20, 22 bzw. 21, 23, der Spannungsteilerstufen wird ein Teilerverhältnis vorgegeben. Vorzugsweise sind die Spannungsteilerstufen und somit ihre Teilerverhältnisse untereinander gleich dimensioniert. Auch die Verstärkungselemente 1 bis 4 sind vorzugsweise untereinander übereinstimmend ausgebildet.

Durch entsprechend gewählte Dimensionierung der Spannungsteilerstufen mit den Widerständen 20 bis 23 und der von den Konstantstromquellen 10, 11 abgegebenen Gleichströme sowie durch Wahl des Verhältnisses der Werte der beiden Steuerspannungen UD1 und UD2 zueinander kann erreicht werden, daß sich im Ausgangssignal, d.h. der Ausgangsspannung UA, Anteile aufheben, die eine Abhängigkeit von einer höheren Potenz der Steuersignale, d.h. der Steuerspannungen UD1, UD2, zeigen. Es sind dies Kreuzmodulationsprodukte mit Anteilen bei ungeraden Frequenzvielfachen der Steuerspannungen UD1, UD2. Durch die Dimensionierung kann ausgewählt werden, welche der Oberschwingungen (Harmonischen) der Steuerspannung UD1 (bzw. der Steuerspannung UD2, die der ersten Steuerspannung UD1 unmittelbar proportional ist) in der Ausgangsspannung UA ausgelöscht werden soll. Vorzugsweise wird die dritte Harmonische kompensiert, d.h. in der Ausgangsspannung UA ausgelöscht, da sie die größte Amplitude von allen auftretenden Oberschwingungen aufweist und somit die größte Störung verursacht.

Für das Beispiel einer nicht gegengekoppelten ersten Differenzverstärkerstufe, d.h. ohne die Emitterwiderstände 30, 31, kann aus der Übertragungskennlinie, d.h. der Abhängigkeit der Ströme in den Hauptstrompfaden der Verstärkungselemente 1, 2 von der Steuerspannung UD1, durch Reihenentwicklung der Tangens-Hyperbolicus-Funktion und Auflösung nach Potenzen der Steuerspannung UD1 für die Kompensation jeder Harmonischen auf analytischem Wege eine Dimensionierungsvorschrift für die Konstantstromquellen 10, 11 und die Spannungsteilerstufen 20, 22 bzw. 21, 23 in Abhängigkeit von dem Proportionalitätsfaktor zwischen den Steuerspannungen UD1 und UD2 gefunden werden. Soll beispielsweise die dritte Harmonische, d.h. die Komponente dritter Ordnung kompensiert werden, muß die Dimensionierung gemäß der folgenden Gleichung vorgenommen werden:

$$UD1^3 \cdot I01 \cdot (R1+R3)=UD2^3 \cdot I02 \cdot R1,$$

wobei mit

I01 der von der ersten Konstantstromquelle 10 abgegebene Gleichstrom,
I02 der von der zweiten Konstantstromquelle 11 abgegebene Gleichstrom,
R1 der ohmsche Widerstandswert des Widerstands 20 der ersten Spannungsteilerstufe und
R3 der ohmsche Widerstandswert des Widerstands 22 der ersten Spannungsteilerstufe

bezeichnet ist. Außerdem gilt die obige Annahme, daß die ohmschen Widerstandswerte der Widerstände 20, 21 übereinstimmen und ferner die ohmschen Widerstandswerte der Widerstände 22 und 23 einander gleich sind. Für den Grundschwingungsanteil UAg der Ausgangsspannung UA ergibt sich dann die folgende Beziehung:

$$UAg=((UD1 \cdot I01)/(2UT)) \cdot (R1+R3) \cdot (1-((UD1^2)/(UD2^2)));$$

dabei ist UT die sogenannte Temperaturspannung des Halbleitermaterials der Verstärkungselemente 1 bis 4.

Durch Wahl eines hinreichend großen Proportionalitätsfaktors zwischen den Steuerspannungen UD1 und UD2 kann der letzte Faktor in dieser Formel möglichst nahe bei dem Wert 1 vorgegeben werden, so daß die Amplitude des Grundschwingungsanteils UAg möglichst wenig reduziert wird. Aus dieser Forderung und mit der erstgenannten Beziehung können nach Vorgabe des Gleichstromes der ersten Konstantstromquelle 10 und beispielsweise der Summe der ohmschen Widerstandswerte R1 und R3 die einzelnen Elemente der Schaltungsanordung bestimmt werden.

In einem Dimensionierungsbeispiel ergeben sich die folgenden Werte:

I01=100 µA,
I02=10 µA,
R1=1,852 kOhm,
R3=3,148 kOhm,
UD2=3·UD1.

Der Grundschwingungsanteil UAg wird damit um lediglich ein dB, d.h. um den Faktor 1,125 reduziert. Gegenüber einem dem Stand der Technik entnehmbaren Dimensionierungsfall ist so mit der Erfindung eine Erhöhung der Amplitude des Grundschwingungsanteils UAg um 2,8 dB erzielt worden.

In vergleichbarer Weise wird die Dimensionierung der Bauelemente der Schaltung gemäß Fig. 2 auch für den Fall der durch die Emitterwiderstände 30, 31 gegengekoppelten ersten Differenzverstärkerstufe vorgenommen. Dabei ist die durch die Gegenkopplungsimpedanzen (Emitterwiderstände) veränderte Übertragungskennlinie zwischen der Steuerspannung und dem Strom im Hauptstrompfad zu berücksichtigen, die anstelle einer geschlossenen, analytischen Auflösung eine numerische Berechnung notwendig macht. Dabei wird von der Kennliniengleichung

$$UD1=UT \cdot ln((I01/2+IC1)/(I01/2-IC1))+2 \cdot R5 +IC1$$

für die erste Differenzverstärkerstufe ausgegangen, wobei mit

IC1 der Wechselstrom im Hauptstrompfad des ersten Verstärkungselements 1 und mit
R5 der ohmsche Widerstandswert der untereinander gleichen Emitterwiderstände 30, 31

bezeichnet ist. Für eine iterative Dimensionierung wird nun vorzugsweise das Verhältnis der Werte der Steuerspannungen UD1, UD2 und die Summe der ohmschen Widerstandswerte R1 und R3. Vorgegeben durch iterative Erhöhung des Wertes für den Gleichstrom I02 der zweiten Konstantstromquelle 11 wird ein Gleichstromwert gefunden, für den der Anteil gewünschter Ordnung in der Ausgangsspannung UA verschwindet. Anschließend kann gemäß der Beziehung

$$I02/I01=(R1+R3)/R1$$

das Verhältnis des ohmschen Widerstandswertes R1 der Widerstände 20, 21 zur Summe der ohmschen Widerstandswerte der Widerstände 20 und 22 bzw. 21 und 23 optimiert werden.

In einem Dimensionierungsbeispiel ergaben sich die folgenden Werte:

UD1 =UD2,

I01=96 µA,

I02=14 µA,

R1=1,8 kOhm,

R3=11 kOhm,

R5=1,2 kOhm.

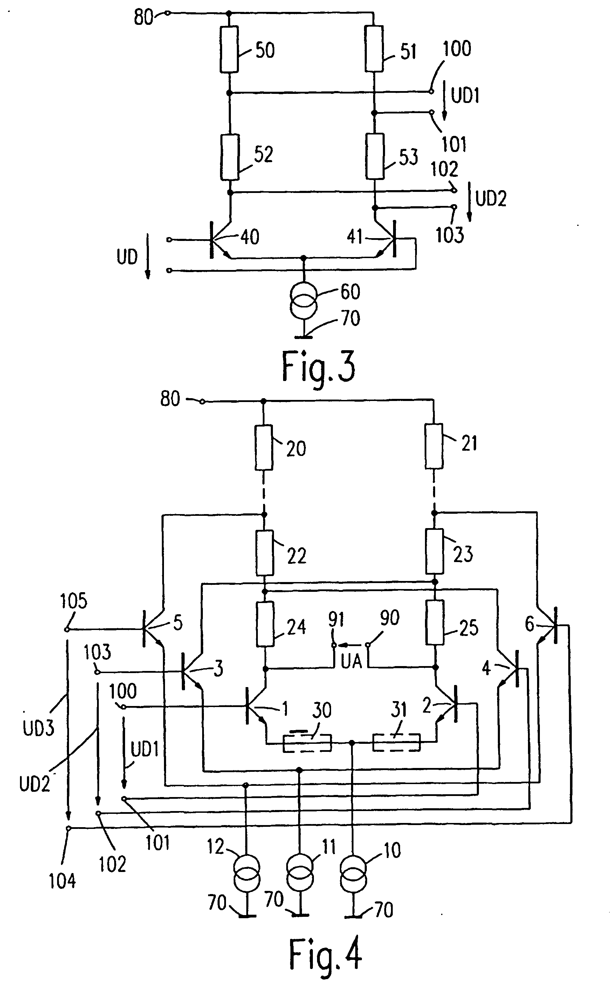

Fig. 3 zeigt ein Beispiel für eine Schaltungsanordnung, mit der aus einer gemeinsamen Steuerspannung UD eine erste und eine zweite Steuerspannung UD1, UD2 abgeleitet werden können, die zueinander in vorgebbarem Verhältnis proportional sind. Diese Schaltungsanordnung weist eine Differenzverstärkerstufe mit zwei npn-Transistoren 40, 41 auf, deren Emitteranschlüsse gemeinsam über eine Konstantstromquelle 60 mit dem Masseanschluß 70 gekoppelt sind. Von jedem der Kollektoranschlüsse der Transistoren 40, 41 führt ein Spannungsteiler aus Widerständen 50, 52 bzw. 51, 53 an den Versorgungsspannungsanschluß 80. Die Kollektoranschlüsse der Transistoren 40, 41 bilden außerdem die Eingangsanschlüsse 102, 103 der zweiten Differenzverstärkerstufe 3, 4 der erfindungsgemäßen Schaltungsanordnung, wohingegen Anzapfungen der Spannungsteiler 50, 52 bzw. 51, 53 die Eingangsanschlüsse 100 bzw. 101 der ersten Differenzverstärkerstufe 1, 2 darstellen. Durch entsprechende Dimensionierung der Spannungsteiler 50, 52 bzw. 51, 53 kann nun in einfacher Weise das Spannungsverhältnis zwischen den Steuerspannungen UD1 und UD2 vorgegeben werden.

Fig. 4 zeigt ein weiteres Ausführungsbeispiel der erfindungsgemäßen Schaltungsanordnung, für welches eine Erweiterung der Schaltungsanordnung nach Fig. 2 zum Kompensieren von gleichzeitig mehr als einer Komponente höherer Ordnung vorgesehen ist. Dabei ist für die zusätzliche Kompensation je einer Komponente je eine weitere Differenzverstärkerstufe vorgesehen, und die Spannungsteilerstufen weisen für jede weitere Differenzverstärkerstufe eine weitere Anzapfung auf. Demgemäß enthält die erste Spannungsteilerstufe in Fig. 4 einen weiteren Widerstand 24, der zwischen dem Widerstand 22 und dem ersten Verstärkungselement 1 in Reihe mit dessen Hauptstrompfad eingefügt ist. Ein entsprechend eingefügter Widerstand 25 findet sich auch in der zweiten Spannungsteilerstufe in Reihe mit dem Hauptstrompfad des zweiten Verstärkungselements 2. Die in Fig. 4 dargestellte dritte Differenzverstärkerstufe aus einem fünften und einem sechsten Verstärkungselement 5 bzw. 6, ebenfalls als NPN-Transistoren ausgebildet, ist entsprechend der zweiten Differenzverstärkerstufe 3, 4 über eine dritte Konstantstromquelle 12 mit dem Masseanschluß 70 verbunden; die Steueranschlüsse der Verstärkungselemente 5, 6 bilden weitere Eingangsanschlüsse 104, 105 der Schaltungsanordnung nach Fig. 4. Diesen Eingangsanschlüssen 104, 105 wird eine dritte Steuerspannung UD3 zugeführt, die ebenfalls proportional zu der ersten Steuerspannung UD1 ist. Durch gestrichelt gezeichnete Verbindungen zwischen den Widerständen 20 und 22 bzw. 21 und 23 der Spannungsteilerstufen ist angedeutet, daß die Schaltung nach Fig. 4 um weitere Elemente in den Spannungsteilerstufen und entsprechend um weitere Differenzverstärkerstufen ergänzt werden kann.

Im übrigen entspricht die Schaltungsanordnung nach Fig. 4 dem ersten Ausführungsbeispiel gemäß Fig. 2. Auch die Dimensionierung der einzelnen Bauelemente wird inentsprechender Anwendung der Dimensionierungsvorschriften vorgenommen, wobei durch die zusätzlichen Widerstände der Spannungsteilerstufen und die zusätzlichen Konstantstromquellen (eventuell außer der dritten Konstantstromquelle 12 noch weitere Konstantstromquellen für weitere Differenzverstärkerstufen) in den Beziehungen zwischen den Schaltungsparametern zusätzliche Freiheitsgrade vorhanden sind, die eine Kompensation einer entsprechenden Anzahl von Komponenten höherer Ordnung ermöglichen.

**Patentansprüche**

1. Schaltungsanordnung mit

- einer ersten Differenzverstärkerstufe mit zwei Verstärkungselementen (1, 2), deren Hauptstrompfade

-- einerseits miteinander und über eine erste Bezugsstromquelle (10) mit einem ersten Bezugspotential (70) gekoppelt sind und
-- andererseits mit je einem Ausgangsanschluß (90, 91) sowie über je eine Ausgangsimpedanz (21, 23, 25; 20, 22, 24) mit einem zweiten Bezugspotential (80) gekoppelt sind und deren Steueranschlüssen (100, 101) ein erstes Steuersignal (UD1) zuleitbar ist, wobei den Ausgangsanschlüssen ein Ausgangssignal (UA) entnehmbar ist,

- wenigstens einer weiteren Differenzverstärkerstufe mit je zwei weiteren Verstärkungselementen (3, 4, 5, 6), deren Hauptstrompfade je einerseits miteinander und über je eine weitere Bezugsstromquelle (11) mit dem ersten Bezugspotential (70) gekoppelt sind und deren Steueranschlüssen ein weiteres Steuersignal (UD2, UD3) zuleitbar ist,

**dadurch gekennzeichnet, daß**

- die Ausgangsimpedanzen als vorzugsweise gleiche Spannungsteiler (20, 22, 24; 21, 23, 25) mit für jede weitere Differenzverstärkerstufe je einer Anzapfung ausgebildet sind,

-- die Hauptstrompfade der weiteren Differenzverstärkerstufen (3, 4; 5, 6) an je zwei paarweise zueinander symmetrische, eine vorbestimmte Teilung aufweisende Anzapfungen beider Spannungsteiler geführt sind,

- die Augenblickswerte der Steuersignale in vorgewähltem Verhältnis zueinander stehen und

- die Teilung der Anzapfungen der Spannungsteiler und das Verhältnis der von den Bezugsstromquellen abgegebenen Ströme derart aufeinander abgestimmt sind, daß sich im Ausgangssignal Anteile aufheben, die eine Abhängigkeit von wenigstens einer höheren Potenz der Steuersignale zeigen.

2. Schaltungsanordnung nach Anspruch 1, **dadurch gekennzeichnet,**
   **daß** die Verstärkungselemente aller Differenzverstärkerstufen wenigstens bezüglich ihrer Hauptstrompfade übereinstimmend dimensioniert sind.

3. Schaltungsanordnung nach Anspruch 1, **dadurch gekennzeichnet,**
   **daß** die Hauptstrompfade der Verstärkungselemente der ersten Differenzverstärkerstufe mit der ersten Bezugsstromquelle über je eine Rückkopplungsimpedanz verbunden sind.

4. Integrierter elektronischer Halbleiterbaustein, **gekennzeichnet durch**
   eine Schaltungsanordnung nach einem der vorhergehenden Ansprüche.

5. Telekommunikationsgerät, **gekennzeichnet durch**
   einen integrierten elektronischen Halbleiterbaustein nach Anspruch 4.

## Claims

1. A circuit arrangement, which includes

   - a first differential amplifier stage with two amplifier elements (1, 2) whose main current paths

     -- on the one hand, are coupled to one another and, via a first reference current source (10), to a first reference potential (70), and
     -- on the other hand, are coupled to a respective output terminal (90, 91) as well as, via respective output impedance (21, 23, 25; 20, 22, 24), to a second reference potential (80), and whose control terminals (100, 101) can be supplied with a first control signal (UD1), an output signal (UA) being available at the output terminals,

   - at least one further differential amplifier stage, each of which including two further amplifier elements (3, 4; 5, 6) whose main current paths on the one hand are coupled to each other and, via a respective further reference current source (11), to the first reference potential (70) and whose control terminals (50) can each be supplied with a further control signal (D2, UD3),

**characterized in that**

- the output impedances are preferably constructed as identical voltage dividers (20, 22, 24; 21, 23, 25) provided with a respective tapping for each further differential amplifier stage (3, 4; 5, 6),

  -- the main current paths of the further differential amplifier stages are connected to each time two pair-wise mutually symmetrical tappings, providing a predetermined division, of the two voltage dividers,

- the ratio of the instantaneous values of the control signals to one another is predetermined, and
- the division of the tappings of the voltage dividers and the ratio of the currents supplied by the reference current sources are adjusted to each other in such a manner that output signal components which exhibit a dependence on at least one higher power of the control signals cancel each other each other out.

2. A circuit arrangement as claimed in claim 1, **characterized in that** the amplifier elements of all the differential amplifier stages are proportioned to one another so as to correspond at least in respect of their main current paths.

3. A circuit arrangement as claimed in claim 1, **characterized in that** the main current paths of the amplifier elements of the first differential amplifier stage are connected to the first reference current source via respective feedback impedance.

4. An integrated electronic semiconductor component, **characterized in that** it includes a circuit arrangement as claimed in one of the preceding claims.

5. A telecommunication apparatus, **characterized in that** it includes an integrated electronic semiconductor component as claimed in claim 4.

## Revendications

1. Circuit avec

   - un premier étage amplificateur différentiel avec deux éléments amplificateurs (12) dont les voies de courant principal
   - sont, d'une part, couplées l'une à l'autre et, par l'intermédiaire d'une première source de courant de référence (10), à un premier potentiel de référence (70) et

- sont d'autre part, couplées à une borne de sortie respective (90, 91) ainsi que, par l'intermédiaire d'une impédance de sortie (21, 23, 25 ; 20, 22, 24), à un deuxième potentiel de référence (80) et

aux bornes de commande (100, 101) duquel peut être amené un premier signal de commande (UD1) tandis qu'un signal de sortie (UA) peut être prélevé aux bornes de sortie,

- avec au moins un autre étage amplificateur différentiel avec deux autres éléments amplificateurs (3,4; 5,6) respectifs dont les voies de courant principal sont respectivement couplées l'une à l'autre et par l'intermédiaire d'une source de courant de référence (11) supplémentaire au premier potentiel de référence (70) respectif et aux bornes de commande (50) duquel peut être amené un autre signal de commande (UD2, UD3) respectif,

     **caractérisé en ce**

- **que** les impédances de sortie sont conçues comme des diviseurs de tension (20, 22, 24 ; 21, 23, 25), de préférence identiques, avec à chaque fois une prise de réglage pour chaque autre étage amplificateur différentiel;
- **que** les voies de courant principal des autres étages amplificateurs différentiels (3,4; 5,6) sont dirigées à chaque fois sur deux prises de réglage de deux diviseurs de tension, symétriques l'un à l'autre par paires et présentant une division préalablement déterminée;
- les valeurs instantanées des signaux de commande se trouvent dans un rapport présélectionné l'un par rapport à l'autre et
- la division des prises de réglage des diviseurs de tension et le rapport des courants délivrés par les sources de courants de référence sont adaptés l'un à l'autre de manière à faire disparaître dans le signal de sortie les composantes qui montrent une dépendance d'au moins une puissance supérieure des signaux de commande.

2. Circuit selon la revendication 1, **caractérisé en ce que** les éléments amplificateurs de tous les étages amplificateurs différentiels sont dimensionnés de manière correspondante du moins par rapport à leur voie de courant principal.

3. Circuit selon la revendication 1, **caractérisé en ce que** les voies de courant principal des éléments amplificateurs du premier étage amplificateur différentiel sont reliées à la première source de courant de référence par l'intermédiaire d'une impédance de rétroaction respective.

4. Composant à semi-conducteur électronique intégré **caractérisé par** un circuit selon l'une des revendications précédentes.

5. Appareil de télécommunication, **caractérisé par** un composant à semi-conducteurs électronique intégré selon la revendication 4.

Fig.1

Fig.2

9

Fig.3

Fig.4